# NEUE EUROPÄISCHE PATENTSCHRIFT

(11) **EP 1 335 644 B2**
(45) Veröffentlichungstag und Bekanntmachung des Hinweises auf die Entscheidung über den Einspruch: **03.03.2010**
(45) Hinweis auf die Patenterteilung: 19.05.2004
(21) Anmeldenummer: 02002749.6
(22) Anmeldetag: 07.02.2002
(51) Int. Cl.: H05K 7/14

(54) **Vorrichtung zum Einstecken und Herausziehen einer Steckbaugruppe**
Extraction-insertion mechanism for a plug-in unit
Mécanisme pour l'insertion et l'extraction d'un module enfichable

(43) Veröffentlichungstag der Anmeldung: 13.08.2003
(73) Patentinhaber: Schroff GmbH, D-75334 Straubenhardt (DE)
(72) Erfinder: Joist, Michael, 76571 Gaggenau (DE); Haag, Volker, 75323 Bad Wildbad (DE); Mazura, Paul, 76307 Karlsbad (DE); Thalau, Klaus-Michael, 76316 Malsch (DE); Weiler, Hans-Jörg, 76375 Ettlingen (DE)
(74) Vertreter: Durm, Frank

(56) Entgegenhaltungen:
- EP-A1- 0 369 025
- EP-B1- 0 330 957
- EP-B1- 0 399 091
- DE-A1- 3 717 219
- DE-C- 4 428 529
- DE-U1- 29 618 631
- US-A- 6 094 353
- 'Schroff, Katalog für die Elektonik 1999/2000',
- DUDEN: 'Deutsches Universalwörterbuch, 4. Auflage', Seite 245

## Beschreibung

Die Erfindung bezieht sich auf eine Vorrichtung zum Einstecken und Herausziehen einer Steckbaugruppe in bzw. aus einem Baugruppenträger, der mindestens eine vordere Modulschiene hat, mit einem im Frontbereich der Steckbaugruppe schwenkbar gelagerten Hebelziehgriff, dessen kurzer Hebelarm mindestens einen Hebelnocken und eine Abdrücknase aufweist.

Die Erfindung findet Anwendung bei Steckbaugruppen, die zum Aufbau von elektronischen und elektrischen Geräten in Steckplätze eines Baugruppenträgers einsetzbar sind. Baugruppenträger zur Aufnahme von einsteckbaren elektronischen Baugruppen sind in der Industrieelektronik seit langem bekannt. In einfachster Ausführung besteht ein solcher Baugruppenträger aus zwei Seitenwänden und vier parallelen Modulschienen, welche mit ihren beiderseitigen Stirnflächen an die beiden Seitenwände angrenzen. Ein Deckblech und ein Bodenblech sowie eine Rückwand können den Baugruppenträger zu einem Gehäuse ergänzen, von dessen offener Frontseite her die Steckbaugruppen auf eingesetzten Führungen eingeschoben werden. Die Modulschienen können auch integrierte Bestandteile des Deckblechs bzw. des Bodenblechs sein; ein solcher Baugruppenträger mit integrierten Modulschienen ist beispielsweise in der DE 198 17 089 C1 beschrieben.

In den Baugruppenträger werden die Steckbaugruppen von der Frontseite her auf Führungen derart hineingeschoben, dass die Teilfrontplatten der Steckbaugruppen aneinander grenzen. Jede Steckbaugruppe ist mit Hilfe von vielpoligen Steckverbindern an der Rückseite des Baugruppenträgers mit einer Rückseitenverdrahtungsplatte, der sogenannten Backplane, verbunden. Durch die immer höheren Packungsdichten auf den einzelnen Steckbaugruppen und die fortschreitende Miniatusierung elektronischer Bauelemente finden Steckverbinder mit immer größerer Polzahl Anwendung. Die einzelnen Kontakte sind dabei in mehreren Reihen nebeneinander angeordnet. Zum Einstecken und zum Herausziehen der Steckverbinder aus den Kontaktleisten sind große Kräfte erforderlich, die proportional zur Anzahl der Pole des Steckverbinders steigen. Ohne geeignete Hilfsvorrichtungen lassen sich weder die Steckbaugruppen aus den Baugruppenträgern lösen, noch lässt sich zuverlässig eine Steckverbindung zwischen der Steckbaugruppe und der Backplane herstellen.

Als Steck- und Ziehhilfen für Steckbaugruppen sind Hebelsysteme mit Betätigungsgriffen in verschiedenen Ausführungen bekannt. Die Steck- und Ziehhilfen sind im oberen und/oder unteren Frontbereich der Steckbaugruppen angeordnet.
Die EP 0 369 025 A1 offenbart eine Vorrichtung nach dem Oberbegriff des Anspruchs 1.

Die Patentschrift DE 44 28 529 C1 offenbart eine Vorrichtung zum Herausziehen von Steckbaugruppen aus einem Baugruppenträger mit einer Modulschiene. Die Steckbaugruppe hat einen Winkelhebel sowie einen Haltebock für eine Frontplatte und eine Leiterplatte. Der um eine Schwenkachse im Haltebock drehbare Winkelhebel besteht aus einem als Griff ausgebildeten langen Hebelarm und einem kurzen Hebelarm, der zwei zur Schwenkachse unterschiedlich entfernte Abdrückschultern aufweist. Die Modulschiene weist eine frontseitig angeformte dünne Leiste auf, die die Modulschiene nach vorne verlängert, so dass ein Überstand, das sogenannte Dach, entsteht. Beim Herausziehen der Steckbaugruppen aus dem Baugruppenträger drücken sich die beiden Abdrückschultern nacheinander von der angeformten Leiste ab.

Die im Stand der Technik bekannten Steck- und Ziehhilfen haben mehrere Nachteile.

Die Abmessungen des frontseitigen Überstands (Dach) der Modulschiene sind durch die Norm festgelegt. Das Dach ist als schmaler Steg mit rechteckigen scharfkantigen Ausnehmungen ausgebildet. Die frontseitige Anlagefläche ist nur wenige Millimeter hoch. Die Abdrückschultern des Hebels können also nur an einer kleinen Anlagefläche angreifen, so dass bei der Übertragung der Hebelkräfte auf die Modulschiene ein sehr hoher Anpressdruck entsteht.

Die Modulschiene und ihr überstehendes Dach sind in der Regel aus Metall hergestellt. Zur Vermeidung von unerwünschtem Metallabrieb sind der Winkelhebel und die Abdrückschultern oft aus Kunststoff gefertigt. Gleiten die Abdrückschultern unter hohem Anpressdruck über die scharfen Kanten der Modulschiene, ergibt sich als zusätzliches Problem, dass sich der Kunststoff durch elastische Verformung an die scharfe Metallkante anpasst. Diese Art von unerwünschtem Formschluss erhöht die bestehenden Reibkräfte zusätzlich.

Die während des Einsteckens und des Herausziehens auftretenden Hebelkräfte weisen eine Komponente in Einschub- bzw. Ausziehrichtung und eine zu dieser Richtung senkrechte Kompomente auf. Die senkrechte Komponente der Hebelkraft wirkt parallel zur Frontseite der Modulschiene auf die schmale Kante des Daches der Modulschiene. Werden sehr hohe Hebelkräfte übertragen, wird die Modulschiene verbogen, so dass der Hebel an der Modulschiene abrutscht und schließlich außer Eingriff kommt. Das Abrutschen des Hebels wird durch die sehr kleine Anlagefläche des überstehenden Daches begünstigt, welche dem Hebel nur ein kleines Widerlager bietet.

Bei Modulschienen ohne nach vorne überstehendes Dach können beim Herausziehen der Steckbaugruppe die Abdrückschultern nur direkt an der Frontseite der Modulschiene angreifen. Die Frontseite der Modulschiene ist aber durch die übliche T-Nut unterbrochen. Die verbleibenden Anlageflächen an der Frontseite, an denen sich die Abdrückschultern abdrücken, sind kaum größer als die Anlageflächen des überstehenden Daches. Es entstehen ebenfalls sehr große Anpressdrücke durch den angreifenden Hebel.

Ein Einhebeln der Steckbaugruppen in den Baugruppenträger ist bisher nur bei Modulschienen mit Dach möglich, da die Abdrückschultern in die Ausnehmungen der Dachleiste der Modulschiene eingreifen und sich an der von der Modulschiene abgewandten Innenfläche dieser Ausnehmungen abdrücken. An gewöhnlichen Modulschienen, also solchen ohne Dach, findet sich kein Widerlager für das Einhebeln.

Der Erfindung liegt die Aufgabe zugrunde, eine Vorrichtung zum Einstecken und Herausziehen einer Steckbaugruppe zu schaffen, mit der auch sehr große Einsteck- und Herausziehkräfte übertragen werden können, wobei Beschädigungen am Baugruppenträger oder an der Steckbaugruppe sicher verhindert werden.

Zur Lösung der gestellten Aufgabe wird von einer Vorrichtung der eingangs erwähnten Art ausgegangen. Gelöst wird die Aufgabe erfindungsgemäß durch ein Druckstück, das an der Modulschiene befestigt ist und die vom Hebelziehgriff übertragenen Kräfte aufnimmt. Das Druckstück weist wenigstens eine Ausnehmung sowie mindestens eine Abdrückschulter auf.

Beim Einstecken der Steckbaugruppe greift der Hebelnocken des Hebelziehgriffs in die Ausnehmung des Druckstücks ein. Die Drehbewegung des Hebelziehgriffs bewirkt, dass der Hebelnocken entlang der Abdrückschulter in die Ausnehmung hineingleitet und gleichzeitig der Drehpunkt des Hebelziehgriffs an der Steckbaugruppe und damit die Steckbaugruppe in Einschubrichtung in den Baugruppenträger hineingedrückt wird. Durch Ausgestaltung einer tiefen Ausnehmung am Druckstück und einer entsprechenden Ausbildung des Hebelnocken lässt sich ein großer Drehwinkel des Hebelziehgriffs und somit ein langer Einziehweg der Steckbaugruppe realisieren. Die Angriffsfläche an der Abdrückschulter des Druckstücks bietet dem Hebelnocken eine größere Fläche als das überstehende Dach der Modulschiene. Der Anpressdruck des Hebelnockens ist deshalb geringer. Die Übertragung auch sehr großer Kräfte durch den Hebelziehgriff auf die Modulschiene wird somit möglich, ohne dass die Gefahr einer Beschädigung besteht.

Das Druckstück kann auch an Modulschienen ohne überstehendes Dach befestigt werden. Werden Modulschienen ohne überstehenden Rand mit erfindungsgemäßen Druckstücken aus- bzw. nachgerüstet, können Steckbaugruppen mit Hebelziehgriffen auch in Baugruppenträgern mit gewöhnlichen Modulschienen ohne Dach verwendet werden. Insofern hat das vorgeschlagene Druckstück die Funktion eines Adapters, mit dem es möglich wird, Baugruppenträger mit Modulschienen ohne Dach nachträglich für die Verwendung mit Hebelziehgriffen auszurüsten. Selbstverständlich kann das Druckstück auch an einer Modulschiene, die in ein Dach- oder Bodenblech eines Baugruppenträgers integriert ist, befestigt werden.

Beim Herausziehen der Steckbaugruppe drückt sich die Abdrücknase des Hebelziehgriffs gegen die Abdrückschulter des Druckstücks ab. Eine solche Abdrückschulter gibt es bei der Modulschiene, die durch die Norm in ihrer Ausgestaltung festgelegt ist, nicht. Das Druckstück hingegen ist durch keine Norm festgeschrieben, denn es handelt sich um ein separates zusätzliches Teil. Die somit freie Gestaltung des Druckstücks ermöglicht insbesondere eine Ausbildung der Abdrückschulter als große und glatte Fläche. Die Abdrückschulter hat damit eine größere Anlagefläche als die Modulschiene, wodurch der Anpressdruck der Abdrücknase des Hebels reduziert wird und wesentlich größere, vom Hebelziehgriff aufgebrachte Kräfte übertragen werden können. Es lassen sich somit auch Steckbaugruppen mit vielpoligen Steckverbindern aus dem Baugruppenträger einfach, zuverlässig und komfortabel herauslösen, bei hohen Standzeiten.

In einer bevorzugten Ausführungsform weist das Druckstück eine zusätzliche Abdrückfläche auf, gegen die der Hebelnocken beim Herausziehen der Steckbaugruppe drückt. Der Abdrückvorgang beim Herausziehen der Steckbaugruppe wird damit auf den Hebelnocken und die Abdrücknase des Hebelziehgriffs aufgeteilt. Besonders vorteilhaft ist es, wenn der Hebelnocken nicht parallel, sondern im spitzen Winkel zu der Abdrücknase ausgerichtet ist. Beim Herausziehen der Steckbaugruppe wird zuerst der Hebelnocken mit dem Druckstück in Eingriff gebracht, während die Abdrücknase zu einem späteren Zeitpunkt gegen das Druckstück drückt. Durch das nacheinander erfolgende Angreifen von Hebelnocken und Abdrücknase lässt sich der vom Hebelziehgriff bewirkte Ausziehweg nahezu verdoppeln.

Vorzugsweise sind die Abdrückschulter und/oder die Abdrückfläche des Druckstücks parallel zur Frontseite der Modulschiene ausgerichtet. Diese Anordnung der Abdrückschulter bzw. Abdrückfläche bieten dem Hebelziehgriff die besten Eingriffmöglichkeiten und einen hohen Wirkungsgrad.

In einer vorteilhaften Weiterbildung der erfindungsgemäßen Vorrichtung ist das Druckstück lösbar an der Frontseite der Modulschiene befestigt. Dies bietet den großen Vorteil, dass zum einen das Druckstück im Falle einer Beschädigung austauschbar ist und zum anderen das Druckstück genau an der Position befestigt werden kann, an der die Steckbaugruppe eingeschoben werden soll, wodurch die Flexibilität erhöht wird.

Vorzugsweise weist das Druckstück wenigstens eine Bohrung zur Aufnahme einer Befestigungsschraube auf. Die Befestigungsschraube erstreckt sich durch die Bohrung hindurch in die T-Nut der Modulschiene. In die T-Nut der Modulschiene ist eine Gewindelochleiste mit Gewindelöchern eingeschoben. Die Befestigungsschraube greift in die korrespondierenden Gewindelöcher der Gewindelochleiste ein und hält damit das Druckstück an der Modulschiene fest.

Das Druckstück kann einen im Querschnitt T-förmigen Fuß aufweisen. Der T-förmige Fuß dient zum Einschieben in die korrespondierende T-Nut der Modulschiene. Der T-förmige Fuß erhöht den Halt des Druckstücks an der Modulschiene, was bei großen Hebelkräften ein Verformen oder Verbiegen des Druckstücks verhindert. Wenn die T-Nut der Modulschiene komplett mit Druckstücken mit T-förmigem Fuß gefüllt wird, halten sie sich gegenseitig in den geforderten Positionen.

In einer bevorzugten Weiterbildung der Erfindung ist an der Steckbaugruppe ein Halteteil befestigt, das eine Gleitführung aufweist. Gleichzeitig ist am Druckstück ein Gleitlager ausgebildet. Das Gleitlager greift in die korrespondierende Gleitführung des Halteteils ein, um die von dem Hebelziehgriff übertragenen Kräfte, die senkrecht zur Einschubrichtung wirken, aufzunehmen. Der Hebelziehgriff und das Halteteil sind beide an der Steckbaugruppe befestigt, so dass sich die senkrecht zur Einschubrichtung wirkenden Kräfte kompensieren.

Die vom Hebelziehgriff übertragenen Kräfte wirken sowohl auf die Abdrückschulter bzw. die Abdrückfläche des Druckstücks als auch auf das Gleitlager des Druckstücks. Die Krafteinwirkung wird auf eine größere Gesamtfläche verteilt, so dass der Anpressdruck sinkt und größere Kräfte des Hebelziehgriffs übertragen werden können. Das Zusammenwirken von Gleitführung und Gleitlager verhindert ein Verformen oder Verbiegen des Druckstücks bzw. der Modulschiene, da die senkrechten Komponenten der Hebelkräfte kompensiert werden. Die in das Gleitlager eingreifende Gleitführung vermeidet auch zuverlässig, dass der Hebelziehgriff außer Eingriff mit dem Druckstück gerät.

Vorzugsweise hat das Halteteil ein Drehlager für den Hebelziehgriff. Das Drehlager kann als Stift oder Schwenkbolzen ausgebildet sein, der durch eine Bohrung im Halteteil geführt wird und an dem der Hebelziehgriff schwenkbar gelagert ist. Das direkte Angreifen des Hebelziehgriffs am Halteteil verbessert die Kraftübertragung weiter, so dass noch höhere Hebelkräfte aufgenommen werden können.

Die Gleitführung am Halteteil ist vorzugsweise als Führungsschiene ausgebildet, die sich parallel zur Einschubrichtung erstreckt. Das Gleitlager am Drückstück ist dann als Nut ausgebildet, die mit der Führungsschiene korrespondiert. Die Führungsnut und die Führungsschiene bewirken automatisch eine Zentrierung der Steckbaugruppe. Die Steckbaugruppe wird senkrecht zur Einschubrichtung in der gewünschten Position fixiert, ist aber gleichzeitig in Einschubrichtung hinund herbewegbar. Führungsschiene und Führungsnut übernehmen somit die Zentrierfunktion, die sonst der im Stand der Technik bekannte Zentrierstift ausübt.

Die Führungsschiene kann einen L-förmigen Querschnitt haben, wobei der kurze L-Schenkel parallel zur Modulschiene des Baugruppenträgers verläuft. Die Führungsnut weist dann einen korrespondierenden rechteckigen Querschnitt auf, so dass ein sicheres Eingreifen der Führungsschiene in die Führungsnut gewährleistet und ein Herausrutschen zuverlässig verhindert wird. Gleichzeitig wird die Zentrierwirkung verbessert und eine gute Übertragung der senkrecht zur Einschubrichtung auftretenden Kräfte ermöglicht. Der L-förmige Querschnitt der Führungsschiene lässt sich technisch einfach fertigen. Er bietet zudem den Vorteil, dass der L-Schenkel der Führungsschiene relativ stark ausgebildet werden kann, um auch großen Kräften Stand zu halten. Ebenso können die Seitenteile der Führungsnut entsprechend stark ausgebildet sein. Der zur L-förmigen Führungsschiene passende rechteckige Querschnitt der Führungsnut lässt sich durch Aussägen oder Fräsen ebenfalls einfach herstellen.

Der kurze Hebelarm des Hebelziehgriffs kann zwei im Abstand voneinander angeordnete Hebelnocken und zwei nebeneinander angeordnete Abdrücknasen aufweisen. Das Druckstück hat dann zweckmäßigerweise ein Mittelteil, zu dessen beiden Seiten sich je eine Abdrückschulter und je eine Ausnehmung befindet, wobei in dem Mittelteil die Führungsnut ausgebildet ist. Das Druckstück weist in diesem Falle einen zum Mittelteil symmetrischen Aufbau auf. Die zweifache Ausbildung der Hebelnocken und der Abdrücknase am kurzen Hebelarm des Hebelziehgriffs korrespondiert mit den zwei Ausnehmungen und Abdrückschultern des Druckstücks. Die Gesamtanlagefläche für den Hebelziehgriff wird dadurch verdoppelt. Beim Einstecken und Herausziehen der Steckbaugruppe halbiert sich so der Anpressdruck. Durch diese Kraftverteilung können auch sehr große Hebelkräfte auf das Druckstück übertragen werden.

Die zwei Hebelnocken des Hebelziehgriffs greifen in die beiden Ausnehmungen auf beiden Seiten der Führungsnut, so dass auch die beiden Hebelnocken eine Zentrierfunktion in Richtung parallel zur Modulschiene übernehmen. Gleichzeitig wird die Zentrierfunktion von der Führungsnut und der Führungsschiene ergänzt. Diese Anordnung nimmt Querkräfte auf, die von benachbarten Steckbaugruppen ausgeübt werden. Die Steckbaugruppe bleibt auch bei seitlich wirkenden Kräften in ihrer korrekten Position.

Ein Ausführungsbeispiel der Erfindung wird nachstehend anhand der beigefügten Abbildungen näher erläutert. Es zeigen:
- Fig. 1: den vorderen Teil eines Baugruppenträgers mit einer darin eingesetzten Steckbaugruppe, in perspektivischer Darstellung;
- Fig. 2a, 2b: die Vorrichtung zum Einstecken und Herausziehen der Steckbaugruppe von Figur 1, in einer Explosionszeichnung;
- Fig. 3: die einzelnen Teile der Vorrichtung von Figur 2a, in vergrößertem Maßstab;
- Fig. 4a bis 4d: die Vorrichtung gemäß Figur 2a während des Herausziehens der Steckbaugruppe, jeweils in Schnittbildern;
- Fig. 5a bis 5d: die Vorrichtung gemäß Figur 2a während des Einsteckens der Steckbaugruppe, jeweils in Schnittbildern;
- Fig. 6: die Vorrichtung gemäß Figur 2a, in einem Vertikalschnitt und in vergrößertem Maßstab;
- Fig. 7a, 7b: das Druckstück der Vorrichtung gemäß Figur 2a im Detail;
- Fig. 8: ein Druckstück mit T-förmigem Fuß.

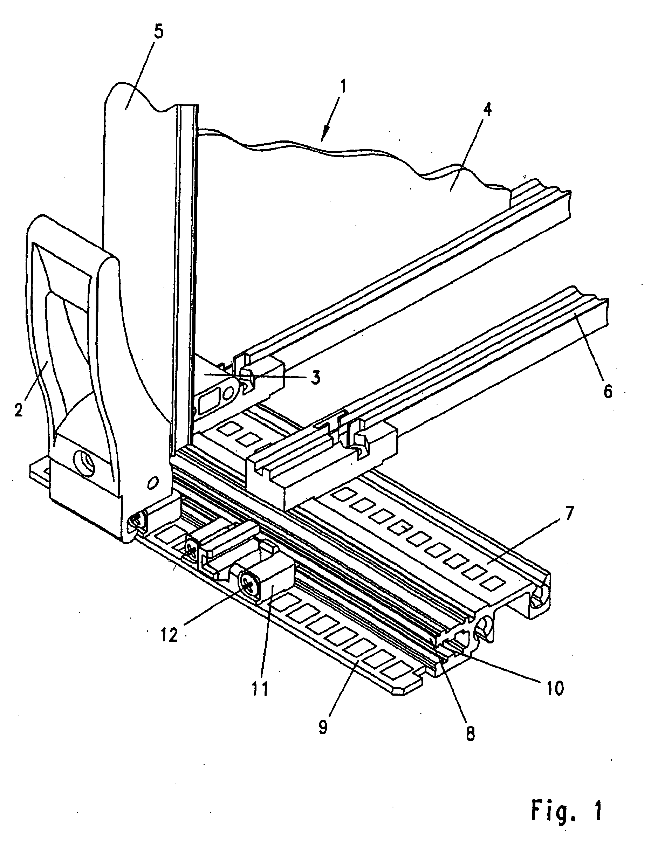

In Figur 1 ist ein Ausschnitt einer Steckbaugruppe 1 dargestellt, welche einen Hebelziehgriff 2, ein Halteteil 3, eine (abgebrochen gezeichnete) Leiterplatte 4 und eine (ebenfalls abgebrochen gezeichnete) Frontplatte 5 aufweist. Die Steckbaugruppe 1 ist in eine Einschubschiene 6 eingeführt. Die Einschubschiene 6 wird von einer vorderen unteren Modulschiene 7, die Teil eines Baugruppenträgers ist, getragen. An der Frontseite 8 der Modulschiene 7 ist eine überstehende schmale Leiste, das sogenannte Dach 9 angeformt. Das Dach 9 weist äquidistant angeordnete Ausnehmungen auf. In der Frontseite 8 der Modulschiene 7 ist eine T-Nut 10 ausgebildet.

Ein Druckstück 11 ist an der Frontseite 8 der Modulschiene 7 befestigt. Das Druckstück 11 wird von dem Dach 9 getragen. Zwei Befestigungsschrauben 12 greifen in die T-Nut 10 der Modulschiene 7 ein und stellen die Verbindung zwischen dem Druckstück 11 und der Modulschiene 7 her.

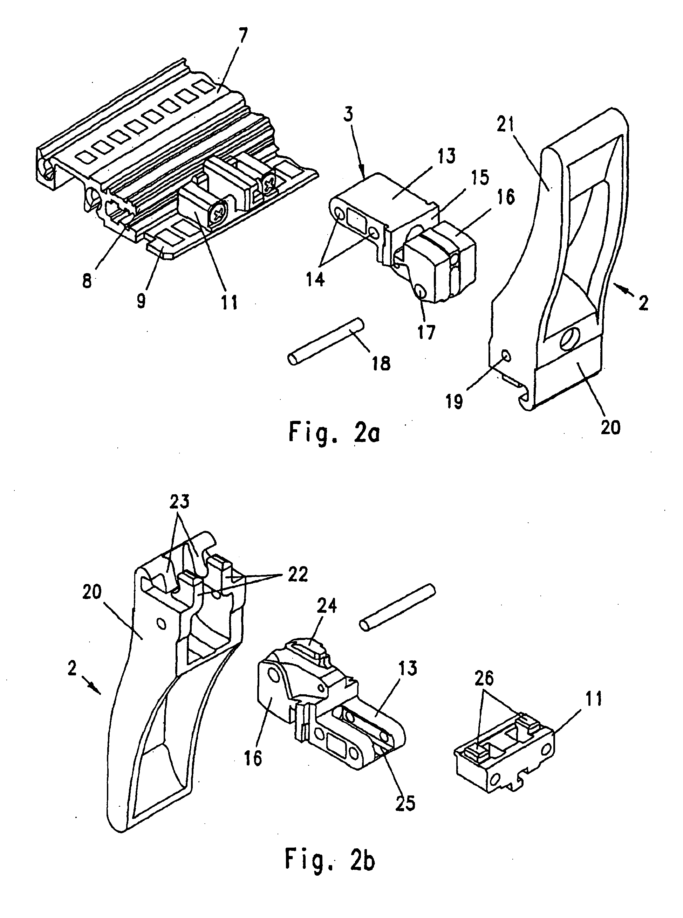

Figur 2a stellt die einzelnen Komponenten der Vorrichtung jeweils von oben gesehen dar. An der Modulschiene 7 ist das Druckstück 11 angeschraubt. Das Druckstück 11 liegt mit seiner Unterseite auf dem flachen Dach 9 auf. Es liegt ferner an der Frontseite 8 der Modulschiene 7 an und verlängert somit die Modulschiene 7 in Einschubrichtung. Das Druckstück 11 schließt mit dem Dach 9 bündig ab.

Das Halteteil 3 weist eine Konsole 13 mit zwei Haltebohrungen 14 auf. Die hier (nicht gezeigte) Leiterplatte 4 wird mit Schrauben an der Konsole 13 des Halteteils 3 befestigt, wobei die Schrauben in die Haltebohrungen 14 eingreifen. Eine Quernut 15 dient zur Aufnahme der (hier nicht dargestellten) Frontplatte. Ein Lagerbock 16 schließt sich an die Quernut 15 an. Im Lagerbock 16 ist ein Drehlager 17 ausgebildet, das als Bohrung quer zur Einschubrichtung ausgeführt ist. Das Drehlager 17 nimmt eine Schwenkachse 18 auf. Die Schwenkachse 18 greift gleichzeitig in Haltelöcher 19 des Hebelziehgriffs 2 ein.

Der Hebelziehgriff 2 weist einen kurzen Hebelarm 20 und einen langen Hebelarm 21 auf. Der lange Hebelarm 21 ist gabelförmig ausgebildet, wobei die beiden Seitengabeln am oberen Ende durch einen Quersteg verbunden sind.

Figur 2b stellt die Komponenten der Vorrichtung aus der entgegengesetzten Perspektive dar. Der Hebelziehgriff 2 weist an seinem kurzen Hebelarm 20 zwei seitliche, voneinander beabstandete, parallel angeordnete Hebelnocken 22 auf. Parallel zu den Hebelnocken 22 sind zwei, ebenfalls nebeneinander angeordnete Abdrücknasen 23 ausgebildet.

Das Halteteil 3 weist an der Unterseite des Lagerbocks 16 eine Führungsschiene 24 auf, die sich in Richtung der Konsole 13 erstreckt. In der Konsole 13 ist eine korrespondierende Längsnut 25 ausgebildet.

Das Druckstück 11 ist in Fig. 2b von seiner Unterseite her zu sehen. Zwei mit Abstand nebeneinaner angeordnete Rastklötze 26 sind an der Unterseite des Druckstücks 11, in der Nähe der Außenseiten, angeformt. Die Anlagefläche des Druckstücks 11, mit der es an der Modulschiene 7 anliegt, ist als ebene Fläche ausgebildet.

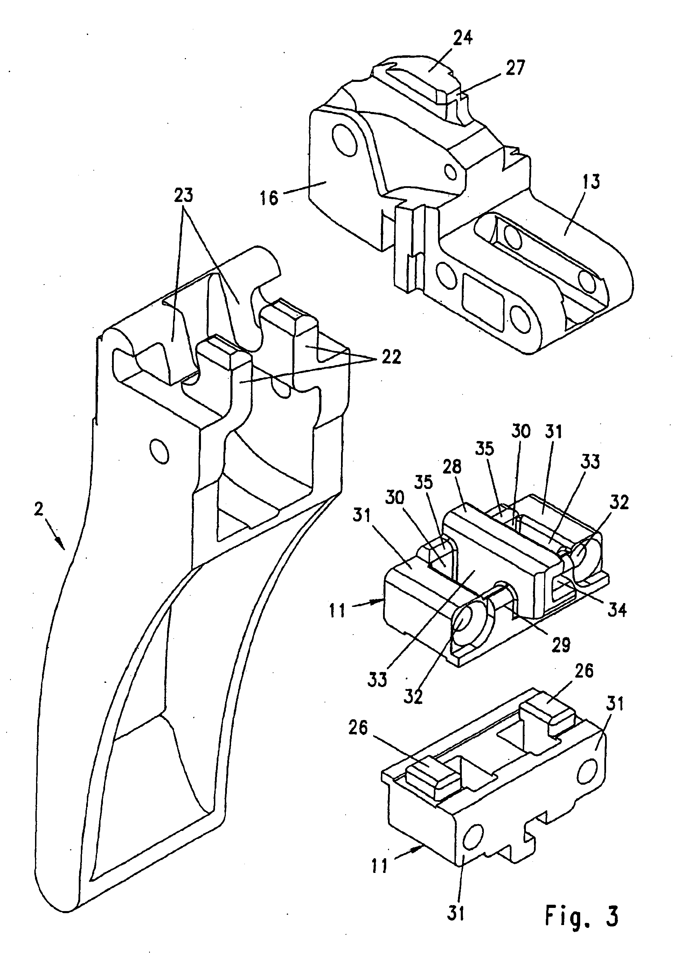

Eine detaillierte Darstellung der Einzelteile der Vorrichtung zeigt Figur 3.

Die am Lagerbock 16 vorgesehene Führungsschiene 24 ist im Querschnitt L-förmig ausgebildet und erstreckt sich in Einschubrichtung. Der kurze L-Schenkel 27 der Führungsschiene 24 ist quer zur Einschubrichtung orientiert. Das von der Konsole 13 entfernt liegende Ende der Führungsschiene 24 verjüngt sich zu einem Keil. Ein von der schmalen Keilseite eingeschobenes Gegenlager kann somit leicht und anfangs mit Spiel über die Führungsschiene 24 gleiten, um mit ihr in Eingriff zu kommen.

Die beiden Hebelnocken 22 des Hebelziehgriffs 2 sind quaderförmig ausgebildet, wobei sich die Enden nach oben hin verjüngen, so dass ein Keilstumpf entsteht. Die Abdrücknasen 23 sind von den beiden Hebelnocken 22 beabstandet. Sie liegen parallel zueinander und fluchten mit dem Hebelnocken 22.

Das Druckstück 11 ist im Wesentlichen symmetrisch aufgebaut. Ein in Einschubrichtung verlaufendes Mittelteil 28 bildet die Symmetrieachse. Zu beiden Seiten des Mittelteils 28 ist je eine Abdrückschulter 29 und je eine Abdrückfläche 30 angeordnet. Die Abdrückschultern 29 und die Abdrückflächen 30 verbinden das Mittelteil 28 mit parallel zum Mittelteil 28 verlaufenden Außenteilen 31. In jedem Außenteil 31 ist eine Bohrung 32 vorgesehen, die sich in Einschubrichtung erstreckt und die zum Aufnehmen einer Befestigungsschraube 12 dient. Das Mittelteil 28 und die Außenteile 31 begrenzen gemeinsam mit der Abdrückschulter 29 und der Abdrückfläche 30 eine Ausnehmung 33, die rechteckigen Querschnitt hat. Aufgrund des symmetrischen Aufbaus des Druckteils 11 ergeben sich zwei, beiderseits des Mittelteils 28 angeordnete Ausnehmungen 33, in welche die Hebelnocken 22 des Heblziehgriffs 2 eingreifen.

Das Mittelteil 28 weist ferner ein Gleitlager auf, das als Führungsnut 34 ausgebildet ist. Die Führungsnut 34 erstreckt sich entlang des Mittelteils in Einschubrichtung, wobei die Öffnung der Führungsnut 34 in Richtung eines der Außenteile 31 und damit quer zur Einschubrichtung weist. Die Führungsnut 34 dient zur Aufnahme der Führungsschiene 24 des Halteteils 3.

Die Abdrückschultern 29, die die Außenteile 31 mit dem Mittelteil 28 verbinden, sind in ihrem oberen Bereich abgerundet, so dass scharfe Kanten an der Oberseite vermieden werden. Die Abdrückfläche 30 ist Teil eines Verbindungsstegs 35, der zwischen dem Mittelteil 28 und dem Außenteil 31 liegt. Der Verbindungssteg 35 ist an seinem oberen Ende abgeschrägt. Er überragt in seinen Abmessungen das Außenteil 31, ist aber niedriger als das Mittelteil 28.

Die an der Unterseite des Druckstücks 11 ausgebildeten Rastklötze 26 sind im Bereich der Außenteile 31 angeordnet. Um scharfe Kanten an der Oberseite der Rastklötze 26 zu vermeiden, sind diese leicht abgeschrägt.

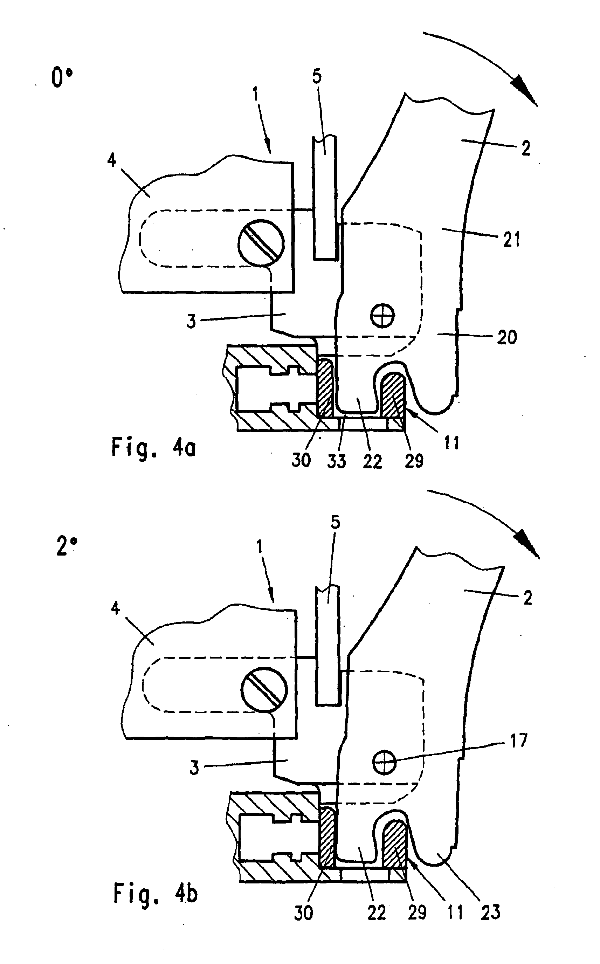

Die Figuren 4a bis 4d zeigen die Funktion der erfindungsgemäßen Vorrichtung beim Herausziehen der Steckbaugruppe 1 aus dem Baugruppenträger.

Fig. 4a zeigt die Steckbaugruppe 1 vollständig in den Baugruppenträger eingesteckt. An dem Halteteil 3 ist die Leiterplatte 4 mittels einer Schraube befestigt. Die Frontplatte 5 ist zwischen der Leiterplatte 4 und dem Hebelziehgriff 2 angeordnet. Der Hebelziehgriff 2 befindet sich in der vertikalen Ausgangsstellung (0°), wobei der kurze Hebelarm 20 senkrecht nach unten weist. In dieser Stellung greift der Hebelnocken 22 in die Ausnehmung 33 des Druckstücks 11 ein, liegt aber weder an der Abdrückschulter 29 noch an der Abdrückfläche 30 des Druckstücks 11 an.

Mit Beginn des Herausziehens der Steckbaugruppe 1 aus dem Baugruppenträger (Fig. 4b) wird der lange Hebelarm 21 des Hebelziehgriffs 2 im Uhrzeigersinn um das Drehlager 17 gedreht. Die Außenfläche des Hebelnockens 22 drückt nun gegen die Abdrückfläche 30. Die Abdrücknase 23 des Hebelziehgriffs 2 berührt die Abdrückschulter 29 des Druckstück 11 noch nicht.

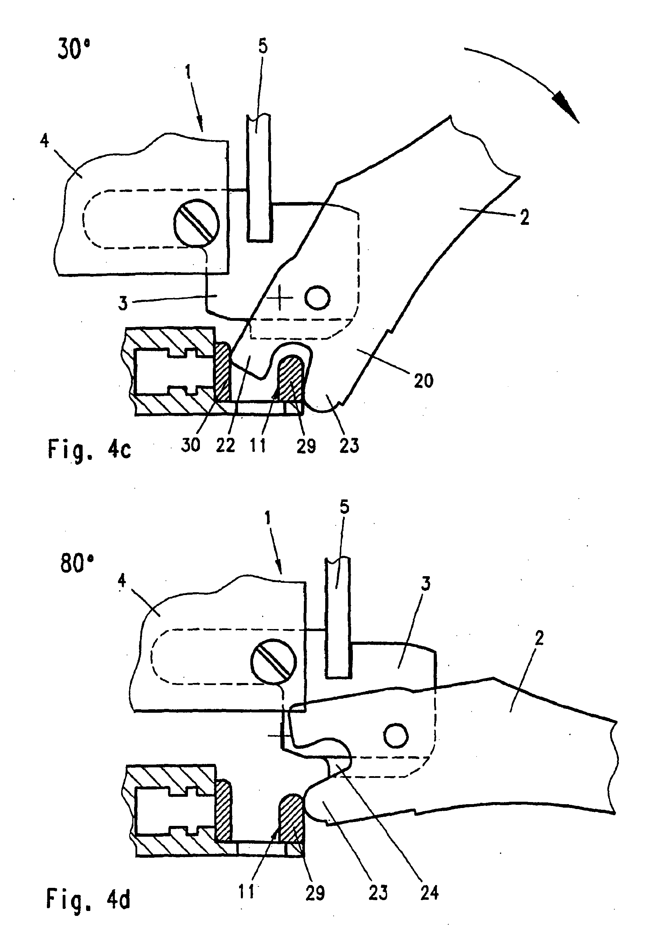

Mit fortschreitender Drehbewegung des Hebelziehgriffs 2, wie in Fig. 4c dargestellt, wandert der Druckpunkt zwischen dem Hebelnocken 22 und der Abdrückfläche 30 vom unteren Bereich der Abdrückfläche 30 nach oben. Noch bevor der Hebelnocken 22 mit der Abdrückfläche 30 außer Eingriff gerät, liegt die Abdrücknase 23 des kurzen Hebelarms 20 an der Abdrückschulter 29 an. Die Kraftübertragung zwischen Hebelziehgriff 2 und Druckstück 11 wird nun sowohl von dem Hebelnocken 22 als auch von der Abdrücknase 23 bewirkt.

Im weiteren Verlauf des Herausziehens der Steckbaugruppe 1 aus dem Baugruppenträger wird der Hebelziehgriff 2 weitergedreht, bis er etwa eine um 80° geneigte Position erreicht (Fig. 4d). Dabei hat sich die Abdrücknase 23 während des Abdrückens von der Abdrückschulter 29 nach oben bewegt und liegt nun im oberen Bereich der Außenseite der Abdrückschulter 29 an. Die Steckbaugruppe 1 ist nun soweit aus dem Baugruppenträger herausgezogen, dass die (nicht gezeigten) vielpoligen Steckverbinder aus den Kontaktleisten herausgezogen sind. In dieser Stellung des Hebelziehgriffs 2, bei der die Steckverbindung gelöst ist, verlässt die Führungsschiene 24 die (nicht dargestellte) Führungsnut 34 des Druckstücks 11.

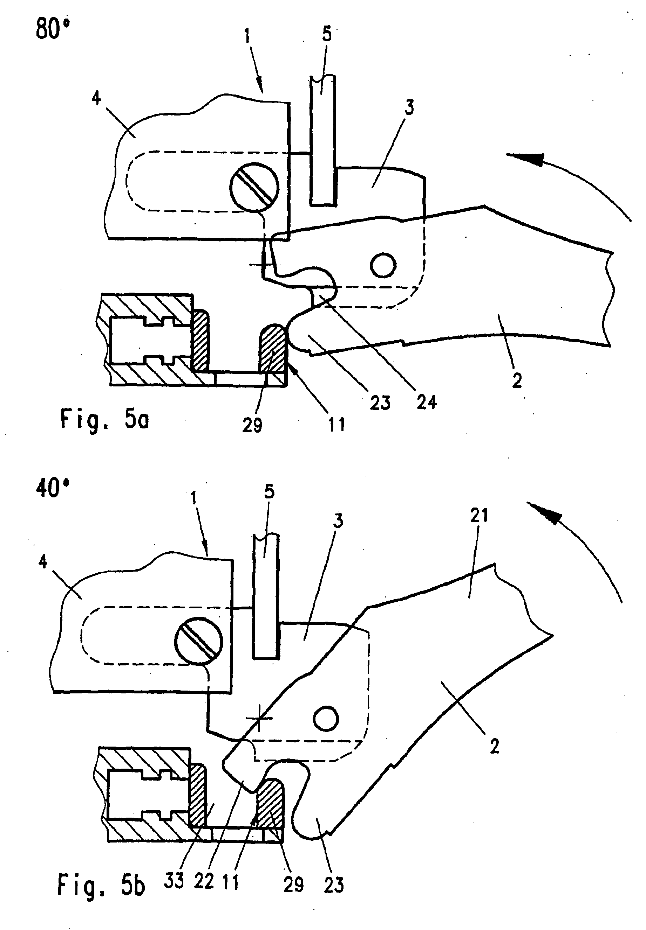

Die umgekehrte Bewegung des Einsteckens der Steckbaugruppe 1 in den Baugruppenträger ist in den Figuren 5a bis 5d dargestellt.

Ausgegangen wird von der Hebelstellung von ca. 80°, bei welcher der Hebelziehgriff 2 nahezu waagerecht ist (Fig. 5a). Die Steckbaugruppe 1 wird zunächst soweit in die Einschubschiene 6 des Baugruppenträgers hineingeschoben, bis die Führungsschiene 24 des Halteteils 3 mit der Führungsnut 34 (vgl. Fig. 2b) des Druckstücks 11 in Eingriff kommt und die Abdrücknase 23 die Abdrückschulter 29 des Druckstücks 11 berührt. Die Steckverbinder am Ende der Leiterplatte 4 berühren die Kontaktleisten der Backplane noch nicht. Das Ineinandergreifen der Führungsschiene 24 und der Führungsnut 34 eilt dem Kontaktieren der Steckverbinder voraus.

Die weitere Verschwenkung des langen Hebelarms 21 des Hebelziehgriffs 2 entgegen dem Uhrzeigersinn bewirkt, dass die Abdrücknase 23 nicht mehr an der Abdrückschulter 29 anliegt (Fig. 5b). Jetzt beginnt aber der Hebelnocken 22, in die Ausnehmung 33 des Druckstücks 11 einzugreifen. Der Hebelnocken 22 drückt im oberen Bereich gegen die Abdrückschulter 29. Die vom Hebelziehgriff 2 übertragene Kraft wirkt schräg von oben gegen die Abdrückschulter 29. Die Vertikalkomponente der Kraft wird durch die Verzahnung der Führungsschiene 24 des Halteteils 3 mit der Führungsnut 34 des Druckstücks 11 kompensiert. Die Horizontalkomponente der Kraft bewirkt eine horizontale Bewegung der Steckbaugruppe 1 in den Baugruppenträger hinein.

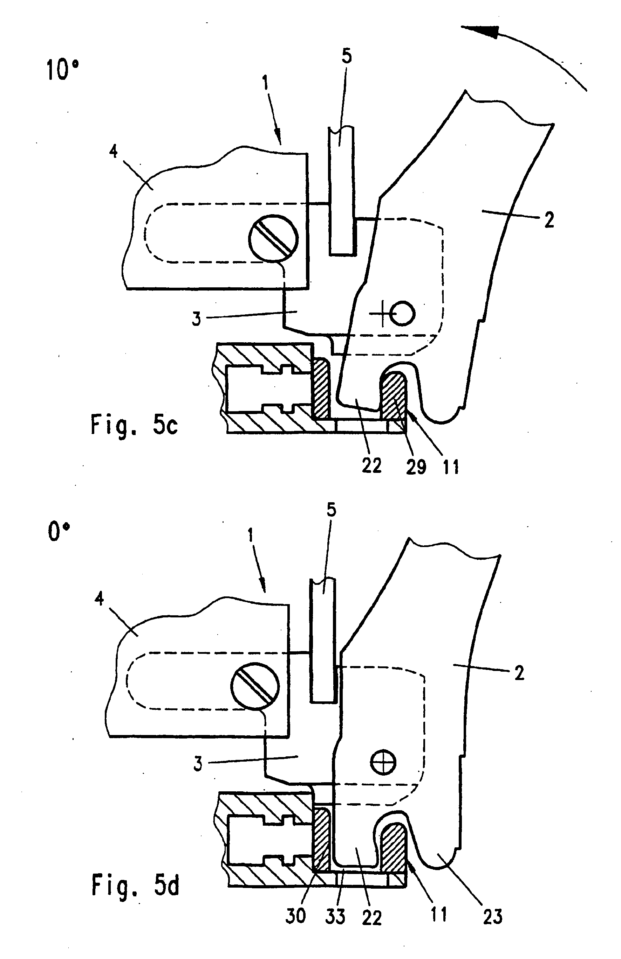

Mit fortschreitender Drehbewegung des Hebelziehgriffs 2 entgegen dem Uhrzeigersinn gleitet der Hebelnocken 22 an der Abdrückschulter 29 entlang nach unten. Dabei drückt der Hebelnocken 22 weiterhin gegen die Abdrückschulter 29 und überträgt somit die Hebelkräfte des Hebelziehgriffs 2 auf das Druckstück 11, was zu einem weiteren Einschieben der Steckbaugruppe 1 in den Baugruppenträger führt (Fig. 5c).
Das Einschieben der Steckbaugruppe 1 in den Baugruppenträger ist vollendet, wenn der Hebelziehgriff 2 in seiner Endstellung (0°) angelangt ist. Der Hebelnocken 22 greift nun vollständig in die Ausnehmung 33 ein, wobei er allerdings weder die Abdrückschulter 29 noch die Abdrückfläche 30 berührt (Fig. 5d).

Sind sowohl der Hebelziehgriff 2 mit dem Hebelnocken 22 und der Abdrücknase 23 als auch das Druckstück 11 mit der Abdrückschulter 29 und der Abdrückfläche 30 aus Metall, zum Beispiel aus Druckguss gefertigt, kann es zu Metallabrieb kommen. Übermäßiger Abrieb wird jedoch dadurch vermindert, dass der Hebelnocken 22 wie auch die Abdrücknase 23 entsprechend groß ausgestaltet sind. Metallabrieb kann aber auch ganz verhindert werden, wenn entweder der gesamte Hebelziehgriff 2 aus Kunststoff besteht oder zumindest der Hebelnocken 22 und die Abdrücknase 23 mit einem Material mit geringem Reibungskoeffizienten überzogen sind. Als Material für einen solchen Überzug bieten sich beispielsweise Kunststoff oder Teflon an.

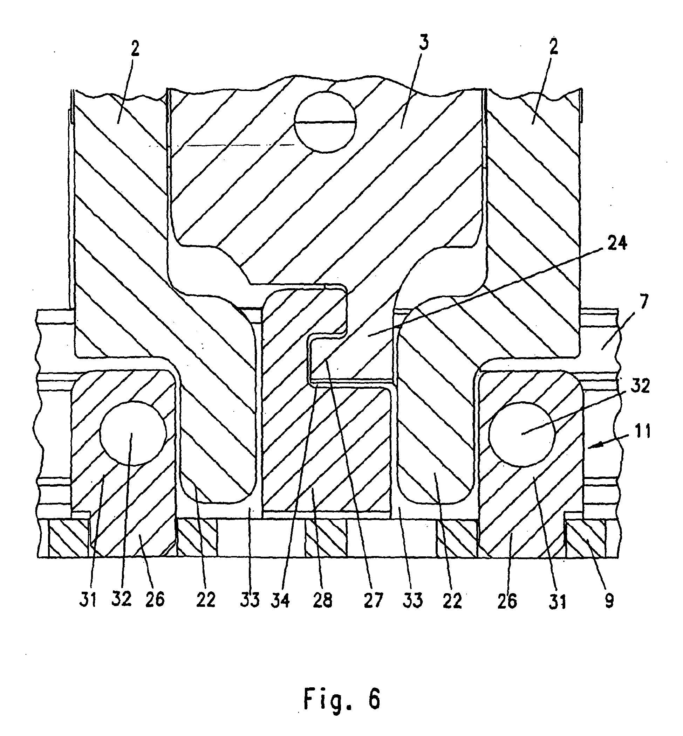

Figur 6 stellt einen Querschnitt durch die erfindungsgemäße Vorrichtung dar. Der Schnitt ist parallel zur Modulschiene 7 durch deren Dach 9 ausgeführt. Entsprechend sind von der Modulschiene 7 nur die Ausnehmungen im Dach 9 und die dazwischen liegenden Stege dargestellt.

Vom Druckstück 11 lässt Figur 6 die beiden Außenteile 31 mit den in Einschubrichtung verlaufenden Bohrungen 32 erkennen. Die Rastklötze 26, die an der Unterseite des Druckstücks 11 angeordnet sind, ragen in die Ausnehmungen des Daches 9 der Modulschiene 7 hinein. Zwischen den beiden Außenteilen 31 liegt das Mittelteil 28 mit der seitlich geöffneten Führungsnut 34. In die Ausnehmungen 33 zwischen den Außenteilen 31 und dem Mittelteil 28 greifen die beiden Hebelnocken 22 des Hebelziehgriffs 2 von oben her ein. Der Hebelziehgriff 2 ist am Halteteil 3 drehbar gelagert. Am Halteteil 3 ist die L-förmige Führungsschiene 24 ausgebildet, wobei der kurze L-Schenkel 27 parallel zur Modulschiene 7 verläuft und in die zur Seite hin geöffnete Führungsnut 34 eingreift.

Zu Beginn des Einziehens der Steckbaugruppe 1 in den Baugruppenträger drücken die Hebelnocken 22 schräg von oben unter einem Winkel von ca. 40° auf die (nicht dargestellten) Abdrückschultern 29 des Druckstücks 11. Dabei wird eine Vertikalkraft von den Hebelnocken 22 auf das Druckstück 11 ausgeübt. Die Hebelnocken 22 und der Hebelziehgriff 2 stützen sich dabei nach oben gegen das Druckstück 11 ab. Gleichzeitig mit dem Hebelziehgriff 2 stützt sich auch das Halteteil 3 nach oben hin ab, das mit dem Hebelziehgriff 2 durch den Schwenkbolzen 18 (vgl. Fig. 2a) verbunden ist. Die Führungsschiene 24 des Halteteils 3, welche sich in Eingriff mit der Führungsnut 34 des Druckstücks 11 befindet, zieht ebenfalls nach oben. Durch das Zusammenspiel der Führungsschiene 24 mit der Führungsnut 34 des Druckstücks 11 und durch die kraftschlüssige Verbindung zwischen dem Halteteil 3 und dem Hebelziehgriff 2, der sich am Druckstück 11 abdrückt, werden die auftretenden Kräfte in vertikaler Richtung größtenteils kompensiert.
Figur 6 lässt auch die Zentrierwirkung der Vorrichtung erkennen. Seitliche, auf die Steckbaugruppe 1 wirkende Querkräfte, die von benachbarten Steckbaugruppen ausgeübt werden, werden durch die Vorrichtung aufgenommen. Die in die Führungsnut 34 eingreifende Führungsschiene 24 fixiert die Steckbaugruppe 1 gegen Querkräfte, die in Richtung des kurzen L-Schenkels 27 der Führungsschiene 24 wirken. In entgegengesetzte Richtung wirkende Kräfte werden durch den Hebelnocken 22 im Zusammenspiel mit der Führungsschiene 24 aufgenommen. Eine Zentrierung der Steckbaugruppe 1 wird auch dadurch erreicht, dass die Hebelnocken 22 in die Ausnehmungen 33 greifen und so durch das Mittelteil 28 bzw. die Außenteile 31 in Position gehalten werden. Die Rastklötze 26, die in die Ausnehmungen des Daches 9 der Modulschiene 7 eingreifen, tragen ebenfalls zu einer Positionierung der Steckbaugruppe 1 bei.

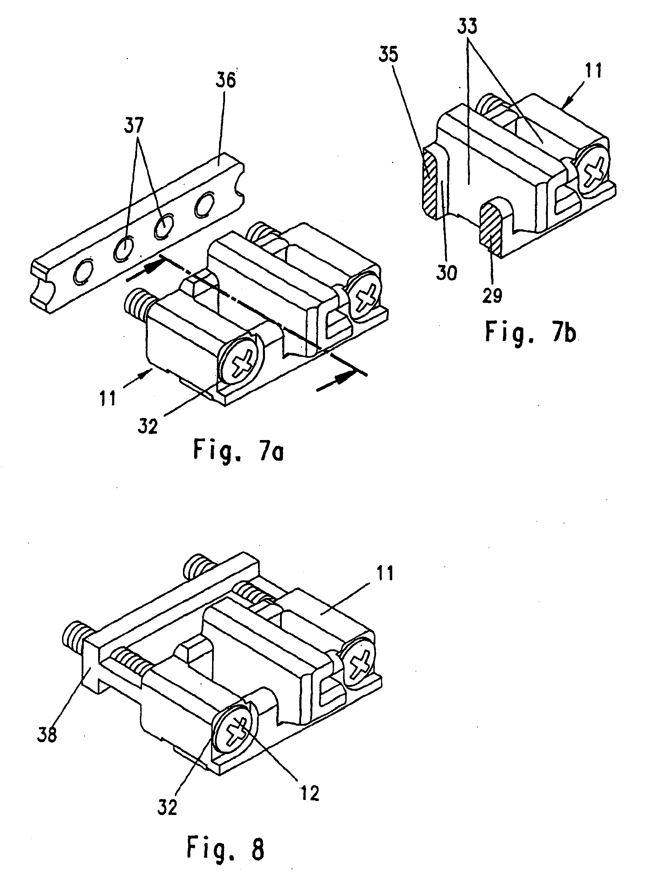

Figur 7a stellt das Druckstück 11 und eine Gewindelochleiste 36 mit Gewindelöchern 37 dar. Die Gewindelöcher 37 in der Gewindelochleiste 36 sind derart ausgebildet, dass sie mit den Bohrungen 32 des Druckstücks 11 korrespondieren. Die Gewindelochleiste 36 wird in die T-Nut 10 der Modulschiene 7 eingeschoben. Die Befestigungsschrauben 12 greifen dann in die Gewindelöcher 37 der Gewindelochleisten 36 ein und befestigen dadurch das Druckstück 11 an der Frontseite 8 der Modulschiene 7.

Durch die Gewindelöcher 37 der Gewindelochleiste 36 wird die Position des Druckstücks 11 bestimmt, so dass das Druckstück 11 mittig vor einem Steckplatz für die Steckbaugruppe 1 angeordnet wird.

Figur 7b zeigt das Druckstück 11 geschnitten entlang der Linie I - I aus Figur 7a. Die Abdrückschulter 29 ist im oberen Bereich abgerundet, so dass das Eingreifen des Hebelnocken 22 entlang der Abdrückschulter 29 beim Einstecken und Herausziehen der Steckbaugruppe 1 in bzw. aus dem Baugruppenträger erleichert wird. Die Abdrückfläche 30 ist die Innenseite des Verbindungsstegs 35; sie ist ebenso als große und glatte Fläche ausgebildet wie die Innen- und Außenseite der Abdrückschulter 29. Zwischen dem Verbindungssteg 35, der Abdrückfläche 30 und der Abdrückschulter 29 befindet sich die Ausnehmung 33.

Figur 8 zeigt eine spezielle Ausgestaltung des Druckstücks 11. An der Anlagefläche des Druckstücks 11 zur Frontseite 8 der Modulschiene 7 ist ein T-förmiger Fuß 38 angeformt. Der T-förmige Fuß 38 korrespondiert mit der T-Nut 10 der Modulschiene 7 und lässt sich seitlich in die T-Nut 10 einschieben. Die Bohrungen 32 des Druckstücks 11 reichen durch den T-förmig ausgebildeten Fuß 38 hindurch. Die Befestigungsschrauben 12 greifen durch die Bohrungen 32 hindurch, so dass eine Schraubverbindung zwischen der T-Nut 10 und dem Druckstück 11 hergestellt werden kann.

### Zusammenstellung der Bezugszeichen

- 1: Steckbaugruppe
- 2: Hebelziehgriff
- 3: Halteteil
- 4: Leiterplatte
- 5: Frontplatte
- 6: Einschubschiene
- 7: Modulschiene
- 8: Frontseite
- 9: Dach
- 10: T-Nut
- 11: Druckstück
- 12: Befestigungsschraube
- 13: Konsole
- 14: Haltebohrung
- 15: Querschlitz
- 16: Lagerbock
- 17: Drehlager
- 18: Schwenkbolzen
- 19: Halteloch
- 20: kurzer Hebelarm
- 21: langer Hebelarm
- 22: Hebelnocken
- 23: Abdrücknase
- 24: Führungsschiene
- 25: Längsnut
- 26: Rastklotz
- 27: L-Schenkel
- 28: Mittelteil
- 29: Abdrückschulter
- 30: Abdrückfläche
- 31: Außenteil
- 32: Bohrung
- 33: Ausnehmung
- 34: Führungsnut
- 35: Verbindungssteg
- 36: Gewindelochleiste
- 37: Gewindeloch
- 38: Fuß

## Patentansprüche

1. Vorrichtung zum Einstecken und Herausziehen einer Steckbaugruppe (1) in bzw. aus einem Baugruppenträger, der mindestens eine vordere Modulschiene (7) mit einer Frontseite (8) hat, mit einem im Frontbereich der Steckbaugruppe schwenkbar gelagerten Hebelziehgriff (2), dessen kurzer Hebelarm mindestens einen Hebelnocken und eine Abdrücknase (23) aufweist, und mit einem
- an der Frontseite (8) der Modulschiene (7) lösbar befestigten Druckstück (11), das die von dem Hebetziehgriff (2) übertragenen Kräfte aufnimmt,
- wobei das Druckstück (11) wenigstens eine Ausnehmung (33) aufweist, in die der Hebelnocken.(22) des Hebelziehgriffs (2) beim Einstecken der Steckbaugruppe (1) eingreift, sowie mindestens eine Abdrückschulter (29), gegen die sich die Abdrücknase (23) des Hebelziehgriffs (2) beim Herausziehen der Steckbaugruppe (1) abdrück,
**dadurch gekennzeichnet, dass** das Druckstück (11) genau an der Position befestigbar ist, an der die Steckbaugruppe (1) eingeschoben werden soll.

2. Vorrichtung nach Anspruch 1, **dadurch gekennzeichnet, dass** das Druckstück (11) eine Abdrückfläche (30) aufweist, gegen die der Hebelnocken (22) beim Herausziehen der Steckbaugruppe (1) drückt.

3. Vorrichtung nach Anspruch 1 oder 2 **dadurch gekennzeichnet, dass** die Abdrückschulter (29) und/oder die Abdrückfläche (30) parallel zur Frontseite der Modulschiene (7) ausgerichtet sind.

4. Vorrichtung nach einem der Ansprüche 1 bis 3, **dadurch gekennzeichnet, dass** das Druckstück (11) wenigstens eine Bohrung (32) zur Aufnahme einer Befestigungsschraube (12) aufweist.

5. Vorrichtung nach einem der Ansprüche 1 bis 4, **dadurch gekennzeichnet, dass** das Druckstück (11) einen im Querschnitt T-förmigen Fuß (38) zum Einschieben in die T-Nut (10) der Modulschiene (7) aufweist.

6. Vorrichtung nach einem der Ansprüche 1 bis 5, **dadurch gekennzeichnet, dass**
- an der Steckbaugruppe (1) ein Halteteil (3) befestigt ist;
- das Halteteil (3) eine. Gleitführung aufweist;
- das Druckstück (11) ein Gleitlager aufweist, in welches die Gleitführung des Halteteils (3) eingreift, um die von dem Hebelziehgriff (2) übertragenen Kräfte, die senkrecht zur Einschubrichtung wirken, aufzunehmen.

7. Vorrichtung nach Anspruch 6, **dadurch gekennzeichnet, dass** das Halteteil (3) ein Drehlager (17) für den Hebelziehgriff (2) aufweist.

8. Vorrichtung nach Anspruch 6 oder 7, **dadurch gekennzeichnet, dass**
- die Gleitführung am Halteteil (3) als Führungsschiene (24) ausgebildet ist, welche sich parallel zur Einschubrichtung erstreckt;
- das Gleitlager am Druckstück (11) als Führungsnut (34) ausgebildet ist.

9. Vorrichtung nach Anspruch 8, **dadurch gekennzeichnet, dass**.
- die Führungsschiene (24) L-förmigen Querschnitt hat, wobei der kurze L-Schenkel (27) parallel zur Modulschiene (7) des Baugruppenträgers verläuft;
- die Führungsnut (34) rechteckigen Querschnitt hat.

10. Vorrichtung nach einem der Ansprüche 1 bis 9, **dadurch gekennzeichnet, dass**
- der kurze Hebelarm (20) des Hebelziehgriffs (2) zwei im Abstand voneinander angeordnete Hebelnocken (22) und zwei nebeneinander angeordnete Abdrücknasen (23) aufweist;
- das Druckstück (11) ein Mittelteil (28) aufweist, zu dessen beiden Seiten je eine Abdrückschulter (29) und je eine Ausnehmung (33) angeordnet sind;
- in dem Mittelteil (28) die Führungsnut (34) ausgebildet ist.

## Claims

1. Device for inserting and withdrawing a plug-in unit (1) in or from a subrack which has at least one front module rail (7) having a front side (8), with a lever pulling handle (2) which is pivotably mounted in the front region of the plug-in unit and the short lever arm of which comprises at least one lever cam and one thrust lug (23), and with a pressure piece (11) which is fastened to the front side (8) of the module rail (7) in a detachable manner and which takes up the forces which are transmitted from the lever pulling handle (2),
- wherein the pressure piece (11) comprises at least one recess (33) in which the lever cam (22) of the lever pulling handle (2) engages when the plug-in unit (1) is inserted, as well as at least one thrust shoulder (29) against which the thrust lug (23) of the lever pulling handle (2) pushes when the plug-in unit (1) is withdrawn,
**characterised in that** the pressure piece (11) is fastenable exactly at the position in which the plug-in unit (1) is to be pushed in.

2. Device according to claim 1, **characterised in that** the pressure piece (11) comprises a thrust face (30) against which the lever cam (22) presses when the plug-in unit (1) is withdrawn.

3. Device according to claim 1 or 2, **characterised in that** the thrust shoulder (29) and/or the thrust face (30) is/are oriented parallel to the front side of the module rail (7).

4. Device according to any one of claims 1 to 3, **characterised in that** the pressure piece (11) comprises at least one bore (32) for accommodating a fastening screw (12).

5. Device according to any one of claims 1 to 4, **characterised in that** the pressure piece (11) comprises a foot (38) with a T-shaped cross-section for pushing into the T-slot (10) of the module rail (7).

6. Device according to any one of claims 1 to 5, **characterised in that**
- a holding part (3) is fastened to the plug-in unit (1);
- the holding part (3) comprises a sliding guide;
- the pressure piece (11) comprises a sliding bearing in which the sliding guide of the holding part (3) engages in order to take up the forces which are transmitted from the lever pulling handle (2) and which act perpendicularly to the push-in direction.

7. Device according to claim 6, **characterised in that** the holding part (3) comprises a pivot bearing (17) for the lever pulling handle (2).

8. Device according to claim 6 or 7, **characterised in that**
- the sliding guide at the holding part (3) is formed as a guide rail (24) which extends parallel to the push-in direction;
- the sliding bearing at the pressure piece (11) is formed as a guide slot (34).

9. Device according to claim 8, **characterised in that**
- the guide rail (24) has an L-shaped cross-section, wherein the short L-leg (27) extends parallel to the module rail (7) of the subrack;
- the guide slot (34) has a rectangular cross-section.

10. Device according to any one of claims 1 to 9, **characterised in that**
- the short lever arm (20) of the lever pulling handle (2) comprises two lever cams (22) disposed at a spacing from one another and two thrust lugs (23) disposed side-by-side;
- the pressure piece (11) comprises a centre part (28) at both sides of which a respective thrust shoulder (29) and a respective recess (33) are disposed;
- the guide slot (34) is formed in the centre part (28).

## Revendications

1. Dispositif pour l'insertion et le retrait d'un module enfichable (1) dans et/ou hors d'un support de module, lequel possède au moins un rail de module (7) avant avec un côté frontal (8), avec une poignée de tirage du levier (2) montée de manière à pouvoir pivoter dans une zone frontale du module enfichable, dont le bras de levier court présente au moins une came de levier (22) et un mentonnet de chasse (23), et avec une
- pièce recevant la pression (11) fixée de manière détachable sur le côté frontal (8) du rail du module (7), qui réceptionne les forces communiquées par la poignée de tirage du levier (2),
- **caractérisé en ce que** la pièce recevant la pression (11) peut être fixée précisément à la position, à laquelle le module enfichable (1) doit être inséré,
- moyennant quoi la pièce recevant la pression (11) présente au moins un évidemment (33), dans lequel la came de levier (22) de la poignée de tirage du levier (2) est en prise lors de l'insertion du module enfichable (1), ainsi qu'au moins un épaulement de chasse (29) sur lequel le mentonnet de chasse (23) de la poignée de tirage du levier (2) prend appui pour se repousser lors du retrait du module enfichable (1).

2. Dispositif selon la revendication 1, **caractérisé en ce que** la pièce recevant la pression (11) présente une surface de chasse (30) sur laquelle la came de levier (22) pousse lors du retrait du module enfichable (1).

3. Dispositif selon l'une quelconque des revendications 1 ou 2, **caractérisé en ce que** les épaulements de chasse (29) et/ou les surfaces de chasse (30) sont orienté(e)s parallèlement au côté frontal du rail de module (7).

4. Dispositif selon l'une quelconque des revendications 1 à 3, **caractérisé en ce que** la pièce recevant la pression (11) présente au moins une forure (32) pour la réception d'une vis de fixation (12).

5. Dispositif selon l'une quelconque des revendications 1 à 4, **caractérisé en ce que** la pièce recevant la pression (11) présente un pied (38) avec un profil transversal en forme de T pour l'insertion dans la rainure en T (10) du rail de module (7).

6. Dispositif selon l'une quelconque des revendications 1 à 5, **caractérisé en ce que**
- un élément de maintien (3) est fixé sur le module enfichable (1),
- l'élément de maintien (3) présente un guide coulissant,
- la pièce recevant la pression (11) présente un palier glisseur dans lequel le guide coulissant de l'élément de maintien (3) est en prise, afin de réceptionner les forces communiquées par la poignée de tirage du levier (2), lesquelles agissent perpendiculairement à la direction d'insertion.

7. Dispositif selon la revendication 6, **caractérisé en ce que** l'élément de maintien (3) présente un coussinet de pivotement (17) pour la poignée de tirage du levier (2).

8. Dispositif selon l'une quelconque des revendications 6 ou 7, **caractérisé en ce que**
- le guide coulissant sur l'élément de maintien (3) est développé en tant que rail de guidage (24), lequel s'étend parallèlement à la direction d'insertion,
- le palier glisseur sur la pièce recevant la pression (11) est développé en tant que rainure de guidage (34).

9. Dispositif selon la revendication 8, **caractérisé en ce que**
- le rail de guidage (24) présente un profil transversal en forme de L, où la branche courte en L (27) s'étend parallèlement au rail de module (7) du support de module,
- la rainure de guidage (34) possède un profil transversal rectangulaire.

10. Dispositif selon l'une quelconque des revendications 1 à 9, **caractérisé en ce que**
- le bras de levier court (20) de la poignée de tirage du levier (2) présente deux cames de levier (22) disposées à distance l'une de l'autre et deux mentonnets de chasse (23) disposés côte à côte,
- la pièce recevant la pression (11) présente une partie médiane (28) des deux côtés de laquelle respectivement un épaulement de chasse (29) et un évidement (33) sont disposés,
- la rainure de guidage (34) est formée dans la partie médiane (28).
